# EUROPEAN PATENT APPLICATION

(11) **EP 2 846 618 A1**
(43) Date of publication of application: **11.03.2015**
(21) Application number: 13183422.8
(22) Date of filing: 06.09.2013
(51) Int. Cl.: H05K 9/00, H01L 23/552

(54) **Radio frequency circuit module**

(71) Applicant: Gemalto M2M GmbH, 81541 München (DE)
(72) Inventor: Walbracht, Jörg, 15732 Schulzendorf (DE)
(74) Representative: Grevin, Emmanuel

(57) **Abstract**

The invention relates to a radio frequency circuit module comprising an internal shield laterally arranged between integrated-circuit components in the interior of a shielding hood and extending vertically from a top section of the shielding hood to a ground-potential contact, for reducing electromagnetic interference between the first and the second integrated-circuit components, wherein the internal shield is formed by one or more shield members which, in any of two principal lateral directions which are parallel to the carrier surface, has a lateral extension that is smaller than the smallest of the side lengths of the first and second integrated-circuit components in the two principal lateral directions.

## Description

The present invention relates to a radio-frequency circuit module.

A radio frequency (RF) circuit module is a circuit module that contains transmission and/or receiving circuitry operating for transmission and reception of electromagnetic signals in the radio-frequency range. Such RF circuit modules find widespread use, for instance in the context of machine-to-machine (M2M) radio communication of data, or in the field of radio communication of speech signals using mobile terminal devices, such as mobile phones, tablet computers or other types of computers.

The document EP 2 285 200 describes a one-piece shielding hood for protecting sensitive circuitry on a circuit board from interference effects caused by electromagnetic fields on the exterior of the shielding hood. Such effects are generally referred to as electromagnetic interference (EMI).

It has also been recognized in the prior art that integrated-circuit components mounted on the same carrier, such as a circuit board, may be the cause for undesired EMI effects. EP 1 091 499 A1 describes solutions to suppress mutual interference between transmitting and receiving circuits in a microwave transmitting- and receiving-module. One solution comprises constructing the transmitting and receiving circuits on different carriers and providing a metal shielding member between the carriers. Another solution is described as using transmission lines of different kinds in the transmitting circuit portion and in the receiving circuit portion on the same surface of a single carrier, such that polarisation planes are orthogonal to each other.

The document WO 2009/129447 describes an EMI shielding structure that includes walls, which define a plurality of individual EMI shielding compartments within the interior of a shielding structure, in order to protect sensitive integrated-circuit components from external as well as internal sources of electromagnetic interference.

According to the present invention, a radio-frequency circuit module comprises
- a carrier having a carrier surface, on which at least a first integrated-circuit component forming a source of electromagnetic fields and a second integrated-circuit component, whose function is impaired by the electromagnetic fields, are mounted at a distance from each other;
- a metallic shielding hood, for reducing electromagnetic interference between electromagnetic fields in an exterior of the shielding hood and electromagnetic fields in the interior of the shielding hood, the shielding hood encapsulating at least the first and the second integrated-circuit component; and
- an internal shield laterally arranged between the first and second integrated-circuit components in the interior of the shielding hood and extending vertically from a top section of the shielding hood to a ground-potential contact, for reducing electromagnetic interference between the first and the second integrated-circuit components.

In the RF circuit module according to the present invention, the internal shield is formed by one or more shield members, which, in any of the two principal lateral directions, which are parallel to the carrier surface, has a lateral extension that is smaller than the smallest of the side lengths of the first and second integrated-circuit components.

The radio-frequency circuit module of the present invention allows achieving a particularly high density of integrated-circuit components on the carrier without losing efficiency in electromagnetic shielding against EMI effects caused by electromagnetic fields generated in the interior as well as in the exterior of the metallic shielding hood. In comparison with the internal shield disclosed in document WO 2009/129447, the radio-frequency circuit module of the present invention allows integrating a larger number of functional units, such as a processor, a memory, a high-frequency processing circuit and a high-frequency power amplifier to be arranged with close spacing, i.e. small distance from each other, on the same carrier, such as a printed circuit board. This is due to the fact that, in comparison with an internal shield in the form of a wall, less space on the interior of the shielding hood is required in preferred embodiments by the particular internal shield structure according of the RF circuit module of the invention, which takes the form of a shield member positioned laterally between the first and the second integrated-circuit components and which, in any of the two principal lateral directions, which are parallel to the carrier surface, has a lateral extension that is smaller than the smallest of the side lengths of the first and second integrated-circuit components.

An integrated-circuit component, as understood herein, is an electronic component having a protective package body that encloses integrated circuitry, which comprises circuit elements electrically interconnected in an inseparable manner on one or more integrated-circuit chips. An inseparable manner of interconnection distinguishes integrated circuitry, for instance on a chip, from a circuit arrangement on a circuit board. In the latter, individual circuit elements (such as transistors, resistors, capacitors, diodes etc.) can be separated from each other and from the circuit board, for instance by soldering, without necessarily destructing the remaining arrangement. Integrated-circuit components in the sense of the present application are also referred to as monolithic integrated-circuit components. The side length of an integrated-circuit component is used above as a reference for comparison with the lateral extension of shield member. The side length of the integrated-circuit component for the purpose of forming this reference is the side length of the package body excluding any contact means that may extend outward from the package body. Most packages have a package body in the form of a cuboid, i.e., have six faces which are in rectangular arrangement to each other. In this case, the side lengths along the two principal lateral directions parallel to the surface of the carrier (e.g., circuit board) are the side lengths of the rectangular top face of the package. Some packages have other shapes, for example a circular shape. In such cases of non-cuboid shapes, the side lengths shall be understood as the respective largest lateral extensions of the package body in the two principal lateral directions parallel to the carrier surface.

The principal lateral directions form correspond to two axes of a rectangular two-dimensional coordinate system that extends parallel to the carrier surface, and may for instance be referred to as the x-direction and the y-direction. In case of a carrier with a rectangular carrier surface shape, the two principal lateral directions extend parallel to the rectangular edges of the carrier surface. In other cases, where the carrier surface shape is not rectangular, any two lateral directions parallel to the carrier surface and at an angle of 90 degrees with respect to each other may be chosen as the principal lateral directions.

The carrier surface shall be assumed to be perfectly flat for the purpose of definition of the two principal lateral directions. The flatness of carriers such as circuit boards may be more or less perfect in reality, but this is irrelevant in the context of the present invention.

The structure of the RF circuit module of the present invention is based on the recognition that an internal shield formed by only one single shield member of small lateral extensions, if laterally positioned between the first and second integrated-circuit components, is sufficient to effectively protect the sensitive second integrated-circuit component from the undesired electromagnetic interference caused by the first integrated-circuit component. which electromagnetic interference, in absence of any internal shield, would disturb the functionality of the second integrated-circuit components. The shield member extends on the interior of the shielding hood and extends vertically from a top section of the shielding hood to a ground-potential contact. The term ground-potential is used herein for denoting a reference potential, to which the shielding hood and the internal shield are connected for an effective shielding of electromagnetic fields.

In contrast to the prior-art RF circuit modules with internal shields described above, the shield member of the present invention has a lateral extension in any (i.e., both) of two principal lateral directions parallel to the carrier surface, that is smaller than the smallest of the side lengths of the first and second integrated-circuit components in the two principal lateral directions. In other words, to identify an RF circuit module according to the present invention, the following can be done: a) determine the longest lateral extension Lₘₐₓ of the shield member from its extensions Lₓ and L_{y} in the principal lateral directions x and y. b) Then determine the shortest side length Sₘᵢₙ of all of the side lengths (parallel to the carrier surface) of the first and second circuit components. c) In an RF circuit module of the present invention, you will find that Lₘₐₓ<S_{min.}

Sₘᵢₙ, forms an upper limit in accordance with the present invention that still achieves a gain in surface area and flexibility. Larger lateral extensions of the shield member would represent a block of some surface area that would impose restrictions on surface area and design flexibility in arranging other circuit components on the carrier surface.

The one or more shield members are arranged laterally between the first integrated-circuit component that forms a source of electromagnetic fields, and the second integrated-circuit component, which can be disturbed by the electromagnetic fields. This way, a propagation of an RF electromagnetic field generated by the first integrated-circuit component along the shielding hood to the lateral position of the second integrated-circuit component is prevented, and electromagnetic interference is efficiently reduced. The shield internal shield is thus fully functional in shielding high-frequency fields coupled from the first integrated-circuit component into the shielding hood by preventing them from propagating along the shielding hood to the lateral position of the second integrated-circuit component, and thus from coupling into that second integrated-circuit component. Shielding of externally generated electromagnetic fields is not reduced.

In the following, preferred embodiment of the radio frequency circuit module of the present invention will be described.

As mentioned, in a preferred embodiment, only a single shield member forming the internal shield is arranged between the first and second integrated-circuit components. This way, the gain in carrier surface area is particularly high. However, it is also possible to use more than one shield member. This is advantageous where the first integrated-circuit component has a very large lateral extension. However, even though a larger number of shield members may be used in principle, it is preferred to keep the number to at most five shield members, in order to achieve a gain in carrier surface area as large as possible in comparison with using a wall-shaped internal shield as described in WO 2009/129447.

Preferably, in cases, where a plurality of shield members forming the internal shield is used between the first and second integrated-circuit component, at least two pin shaped members are in contact with a respective individual ground-potential contact field. By using individual ground-contact fields for different shield members forming the internal shield, the carrier surface between the ground-potential contact fields can be used for arranging different integrated-circuit components thereon, which are not EMI sensitive.

In preferred embodiments, at least one of the one or more ground-potential contact fields is arranged on the carrier surface. However, alternative arrangements of the ground-potential field are possible. In one such alternative, at least one of the one or more ground-potential contact fields is arranged on a cover of a third integrated-circuit component that is mounted on the carrier surface. That third integrated-circuit component is typically not EMI sensitive.

The shield member is advantageously either cut out or punched out of the top section of the shielding hood and bent towards the interior of the shielding hood. Accordingly, in such embodiments, the shielding hood has a small hole next to a connection point of the shield member with the top section of the shielding hood. This structure is not only particularly effective in saving surface area on the carrier, but also particularly cost-saving in the fabrication of an effective internal shield. The fabrication process for a RF circuit module with adequate shielding is simplified in that no shielding walls need to be fabricated and positioned on the circuit board. Furthermore, the material expenditure is reduced, since the internal shield is fabricated from the material required anyway for providing the shielding hood.

A two-dimensional cross-sectional shape of the shield member in a plane that is parallel to the carrier surface is not essential and can be adapted to a particular application case. In different embodiments, the shield member has a circular, oval, elliptic, triangular, rectangular or other polygonal cross-sectional shape. Alternative embodiments thus have shield members in the form of a tab, of a blade or of a pin.

While the cross-sectional plane is typically also perpendicular to a longitudinal direction of extension of the member between the shielding hood and the ground-potential contact, this is not necessarily the case in all embodiments. In other words, the shield member is in some embodiments at an angle to the carrier surface, which differs from 90 degrees. This accounts for more flexibility in the arrangement of integrated-circuit components on the carrier surface, but may, in some embodiments, generate additional boundary conditions for the process of mounting the shield member. For instance, a mounting-robot motion performed for of the positioning of a shielding hood integrating the shield member may need to deviate at some point in time from a mere vertical downward motion if the shield member is oriented with an angle other than 90 degrees with respect to the carrier surface.

In accordance with the described advantages of the RF circuit module of the present invention, a preferred embodiment of a radio frequency circuit module using the shield structure of the present invention has a particularly high coverage of the carrier surface and has EMI insensitive integrated-circuit components arranged between the first and second integrated-circuit components where according to the prior art an internal shielding wall had to be placed. Preferred embodiments making use of this advantage may thus be described by that any straight line that can be drawn on the carrier surface cutting through a lateral position of the at least one shield member crosses at least one further integrated-circuit component mounted on the carrier surface. In other words, the carrier surface of such embodiments is particularly densely packed with integrated-circuit components. This achievement is particularly important in view of increasing requirements of miniaturization of RF circuit modules in many application cases, for instance in the field of automotive applications or logistics applications.

In the following, further embodiments will be described with reference to the figures.
Fig. 1 shows a schematic top view of an RF circuit module according to the prior art;
Fig. 2 shows a schematic cross-sectional view of the RF circuit module of Fig. 1 along the line II-II shown in Fig. 1, in accordance with the prior art;
Fig. 3 shows a schematic top view of an embodiment of an RF circuit module according to the present invention;
Fig. 4 shows a schematic cross-sectional view of the RF circuit module of Fig. 3 along the line IV-IV shown in Fig. 3;
Fig. 5 shows a schematic cross-sectional view of an RF circuit module according to a further embodiment of the present invention;
Fig. 6 shows a schematic cross-sectional view of an RF circuit module according to a further embodiment of the present invention;
Fig. 7 shows a perspective view of a further embodiment of an RF circuit module according to the present invention;
Fig. 8 shows an alternative perspective view of another embodiment of an RF circuit module, and
Fig. 9 shows a sectional perspective view of the embodiment of Figs. 7 and 8, the section being made along the line IX-IX shown in Fig. 7; and
Fig. 10 shows top view of a section of a further embodiment of an RF circuit module according to the present invention.

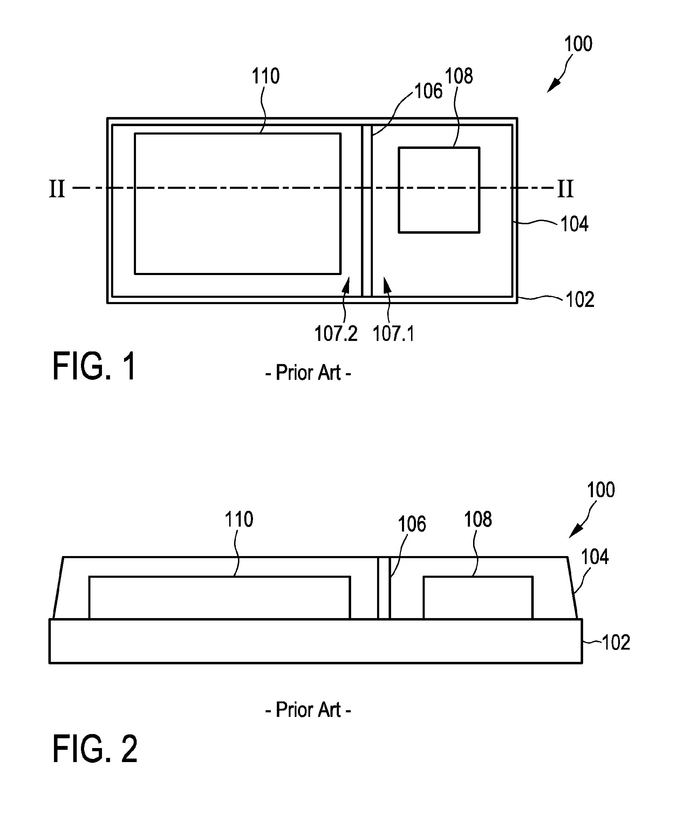

In the following, reference will be made to Figures 1 and 2 in parallel. Fig. 1 shows a schematic top view of an RF circuit module 100 according to the prior art and Fig. 2 shows a schematic cross-sectional view of the RF circuit module 100 of Fig. 1 along the line II-II shown in Fig. 1, in accordance with the prior art.

The RF circuit module 100 of Figures 1 and 2 comprises on a circuit board 102, on which a shielding hood 104 is arranged. In the view of Fig. 1, a top surface of the shielding hood is not graphically represented so as to make the interior of the shielding hood visible for the purpose of the present description. The top surface of the shielding hood 104 is conductively connected to an internal shield that takes the form of a shielding wall 106, which extends on the circuit board 102 and in the interior of the shielding hood 104. The shielding wall 106 is in contact with a ground-potential plane (not shown) of the circuit board 102. Together with the four sidewalls of the shielding hood 104, the shielding wall 106 partitions the interior between the circuit board 102 and the shielding hood into separate compartments. In the present example, for reasons of simplicity, one two compartments each enclosing only one respective integrated-circuit component are shown. In real applications, an RF circuit module may comprise many more integrated-circuit components, and may require more than two compartments to provide adequate shielding of the integrated-circuit components from each other during operation.

Specifically, in the example of Figs. 1 and 2, in a first compartment 107.1 a first integrated-circuit component 108 is arranged, and in a second compartment 107.2, a second integrated-circuit component 110 is arranged. The first and second components 108 and 110 require shielding from each other in view of electromagnetic fields generated during operation of the RF circuit. For instance, the first integrated-circuit component may be a RF power amplifier. Examples of the second integrated-circuit component that requires shielding against electromagnetic fields generated by the first integrated-circuit component for undisturbed operation are a baseband processor or an RF modulation circuit.

In operation of the RF circuit module 100, the first integrated-circuit component 108 thus forms a source of a high-frequency or a radio-frequency electromagnetic field that propagates within the interior of the shielding hood 104 and couples into the shielding hood 104 itself. In absence of the shielding wall 106, the generated electromagnetic field would also propagate along the surface shielding hood 104 and reach the lateral position of the second integrated-circuit component 110. However, due to the presence of the shielding wall 106, a propagation of the electromagnetic field over the full extension of the shielding hood is at least strongly reduced or even fully avoided. The internal shielding 106 also blocks a propagation path of the electromagnetic field generated by the first integrated-circuit component 108 within the interior of the shielding hood 104 into the second compartment containing the second integrated-circuit component 110. The second integrated-circuit component 110 is sensitive to the electromagnetic field generated by the first integrated-circuit component 108 and would be disturbed in its operation, if for instance such electromagnetic fields would be allowed to couple into electronic circuits comprised by the second integrated-circuit component 110.

The shielding wall 106 is typically soldered to a ground-contact field on the surface of the circuit board 102. To this end, i.e., for contacting the shielding wall 106, a strip of the circuit board surface with a lateral extension of up to one millimeter is used. The surface area consumed by the shielding wall further increases by the requirement arranged integrated-circuit components at a certain distance to the ground contact strip in order to securely avoid undesired short cuts. Typical prior-art products of this kind having two chambers separated by the shielding wall 106 exhibit a loss of approximately 3 mm of surface space between the chambers.

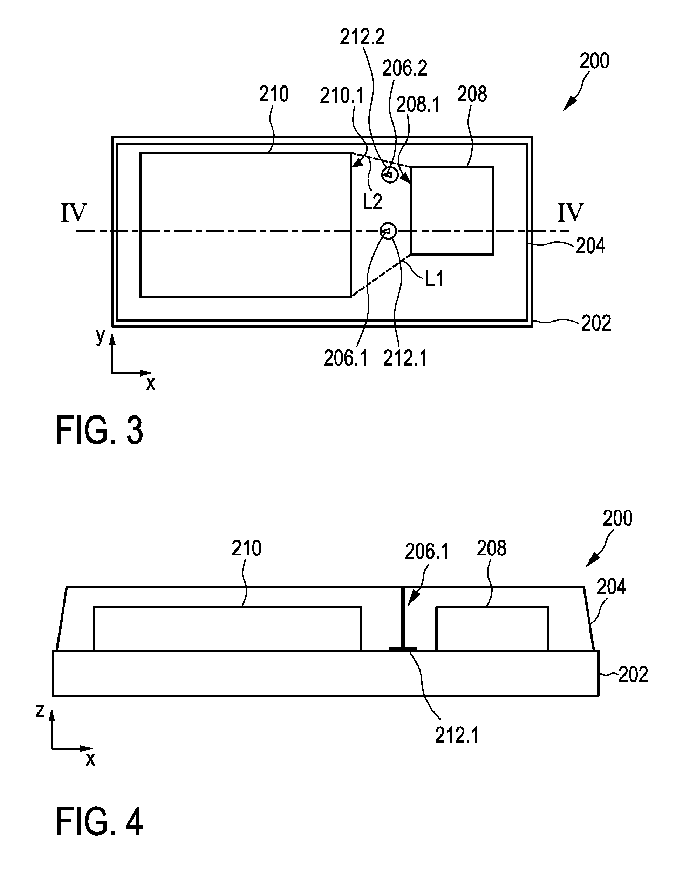

In the following, reference will be made to Figures 3 and 4 in parallel. Fig. 3 shows a schematic top view of an RF circuit module 200 according to the prior art and Fig. 4 shows a schematic cross-sectional view of the RF circuit module 200 of Fig. 3 along the line IV-IV shown in Fig. 3.

To make understanding of the present description easier, the embodiment of Figs. 3 and 4 has been adapted to be alike the embodiment of Figs. 1 and 2. In many features, the RF circuit module 200 of Figures 3 and 4 therefore corresponds to the circuit module 100 of Figures 1 and 2. For this reason, the reference labels in Figs. 3 and 4 for like features in comparison with the embodiment of Figs. 1 and 2 have been chosen to correspond in their last two digits. Reference is made to the above description, with the exception of the following distinguishing features.

The RF circuit module 200 is strongly distinguished from the circuit module 100 according to the prior art in that it does not comprise the internal shielding wall 106. In contrast, effective shielding against electromagnetic fields propagating from the first integrated-circuit component 208 through the interior of the shielding hood 204 and through the top surface of the shielding hood 204 is provided by two pin-shaped shield members 206.1 and 206.2, which are made of a metal and connected with the top surface of the shielding hood 204 and a respective ground contact field 212.1, 212.2 on a surface of the circuit board 202. The ground contact fields 212.1 and 212.2 are connected to a ground plane (not shown) provided as a feature of the circuit board 202. The ground contact fields can for instance be formed by a soldering pad. For the shield members and the ground-contact fields, any material suitable for allowing propagation of high frequency or radio-frequency electromagnetic fields internally or along a surface formed from this material can be used. Such materials are per se known in the art.

In order to provide effective shielding of electromagnetic fields propagating on the shielding hood 204, the shield members 206.1 und 206.2 are laterally positioned between the first integrated-circuit component 208, which generates the undesired electromagnetic fields, and the second integrated-circuit component 210, which is sensitive to the generated electromagnetic field. The arrangement of the shield members 206.1 and 206.2 is therefore possible on any point of a straight line that originates at that side surface 208.1 of the first integrated-circuit component 208, which is oriented towards the second component and terminates on that surface 210.1 of the second integrated-circuit component, which is oriented towards the first integrated-circuit component. Two dashed lines L1 and L2 shown in Fig. 3 indicate limits of a suitable range of lateral positions along a direction marked y in the lower left of Fig. 3. The position of the shield members 206.1 and 206.2 along a direction x between the first and second integrated-circuit components 208 and 210 is not critical, as long as only the second integrated-circuit component 210 is to be protected from undesired electromagnetic fields. As will be shown further below, in other application cases, which require the protection of more than one second integrated-circuit component from electromagnetic radiation generated by a first integrated-circuit component, an arrangement of the shield members with a small lateral distance from the first integrated-circuit component may be desirable.

The pin-shaped shield members 206.1 and 206.2 have a lateral extension in the range of about 1 millimeter in both lateral directions x and y.

As is immediately visible from the top view of Fig. 3, and as will be further elucidated in the context of other embodiments described herein further below, the internal shielding in the form of shield members 206.1 and 206.2, which are arranged laterally between the first integrated-circuit component and the second component provides a gain in available surface area on the surface of the circuit board 202. This can be used for rearranging integrated-circuit components in comparison with the prior-art solution, or for adding additional or larger integrated-circuit components.

It is important to note that other embodiments have only one single shield member between the first and the second integrated-circuit component. It is thus not a requirement to use two or more such shield members, as is the case in the exemplary embodiment of Fig. 3. The number is adaptable in the design process of the RF circuit module according to the desired specific arrangement of integrated-circuit components on the circuit board 202.

In other embodiments, the number of shield members may be further increased, in particular in those embodiments that profit from an internal shielding in different directions, i.e., over a wider range of lateral directions around the first integrated-circuit component. It is for instance advantageous that at least one shield member is laterally positioned between any first integrated-circuit component that generates undesired electromagnetic fields and any second integrated-circuit component, that is sensitive to the generated electromagnetic fields, in order to optimize protection. In solutions according the prior art, this would have required a set of shielding walls forming different compartments, and would therefore have required a rather large area of the surface of the circuit board 202 in order to accommodate the shielding walls according to the prior art.

For example, an embodiment (not shown) differing from that of Figs. 3 and 4 in that, in addition to the second integrated-circuit component 210, a further RF sensitive ("second") integrated-circuit component is arranged on a side of the first integrated-circuit component 208 that is laterally opposite to that of the component 210, would profit from an arrangement of at least one further shield member of the type of the shield members 206.1 and 206.2 positioned laterally between the first integrated-circuit component 208 and that further RF-sensitive integrated-circuit component, and suitably connected to a ground-contact field.

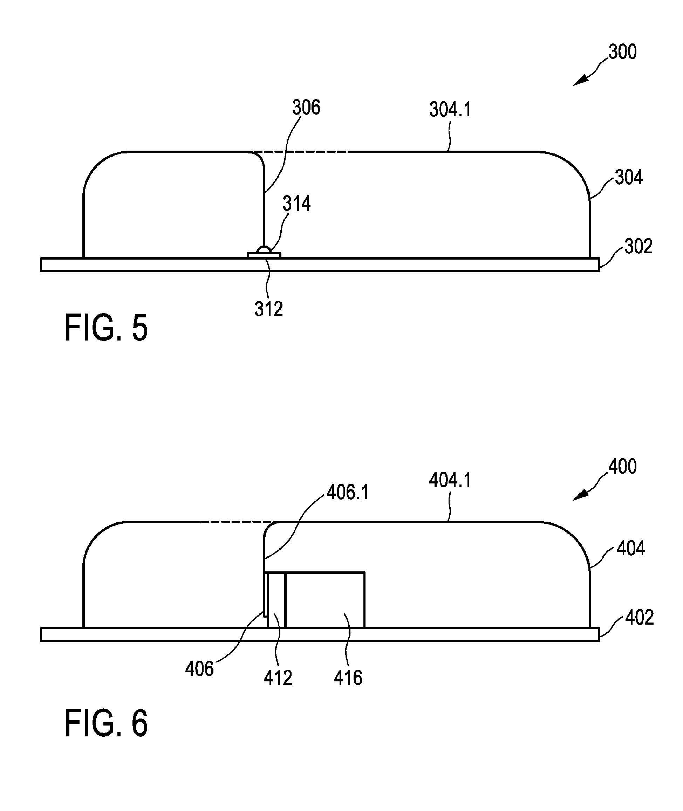

Fig. 5 shows a schematic cross-sectional view of an RF circuit module 300 according to a further embodiment of the present invention. Again, the second and third digits of the reference labels are used to indicate like elements in comparison with the embodiments of the previous Figs.

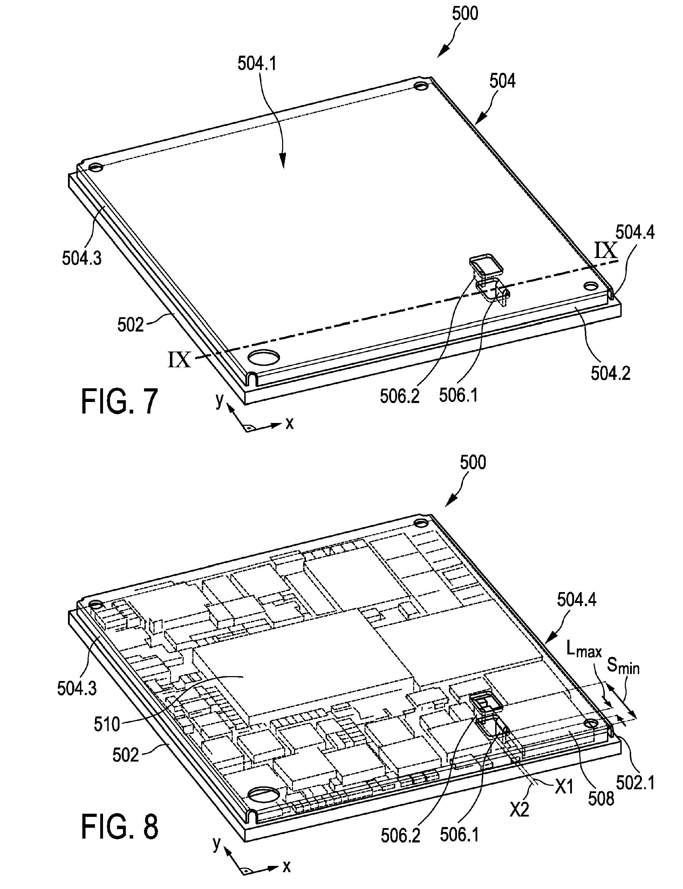

The circuit board 300 shows an embodiment, in which the shield member 306 is formed from the material of the shielding hood 304. To this end, a portion of a top surface 304.1 of the shielding hood is cut and bent downwards towards the circuit board 302 and connected at its longitudinal end (tip) to a ground plane (not shown) of the circuit board 302 by means of a soldering point 314 on a soldering pad 312, which is connected with the ground plane of the circuit board 302. Further embodiments of this type will be shown below in the context of Figures 7 to 9.

Fig. 6 shows a schematic cross-sectional view of an RF circuit module 400 according to a further embodiment of the present invention.

This embodiment of the RF circuit module 400 has the shield member 406 contacted not to a separate ground contact field, but to a ground contact 412 of a integrated-circuit component 416. The ground contact 412 is formed by a metal field that is connected to the ground plane of the circuit board 402. The shield member 406 of this embodiment is cut and bent like that of the embodiment of Fig. 5. However, the contact is not established through the tip of the shield member 406, but through a side surface 406.1. The shield member may be fixed to the ground contact field 412 of the integrated-circuit component 416 by soldering or any other means of electrically conductive fixation.

The integrated-circuit component 416 is in different embodiments either the first integrated-circuit component or the second integrated-circuit component.

However, in another embodiment it is a third integrated-circuit component that is not sensitive to an electromagnetic field and at the same time does not generate such an electromagnetic field.

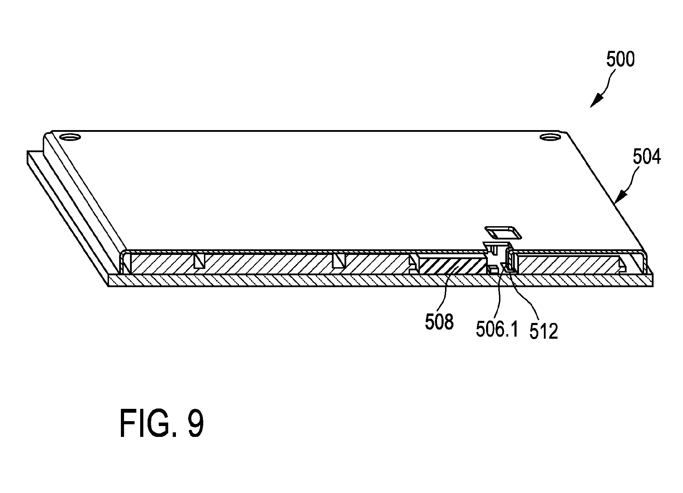

Figures 7 to 9 show three different views of a further embodiment of a RF circuit module 500 according to the present invention. Fig. 7 is a perspective view of the RF circuit module 500 as seen from above at an angle. Fig. 8 is a view corresponding to that of Fig. 7, with the shielding hood being displayed in transparent form for the purpose of showing further detail of the RF circuit module 500, in particular the arrangement of circuit components on the carrier. Fig. 9 is a perspective sectional view of the RF circuit module 500, the section being made along a line IX-IX shown in Fig. 7.

The RF circuit module 500 comprises a single metallic shielding hood 504, which is made from a single piece of metal. The sidewalls of the shielding hood 504 are bent from the top surface 504.1 towards the circuit board 502, as clearly visible for the sidewalls 504.2, 504.3 and 504.4. Shield members of tab-shape forming the internal shield are provided and shown under reference numbers 506.1 and 506.2. They are cut out from the top surface 504.1 and bent down towards the surface of the circuit 502 in the fabrication process of the shielding hood 504, i.e., before positioning the shielding hood 504 on the circuit board 502. The sidewalls 504.2 to 504.4 are in electrical contact with a ground plane of the circuit board 502. The same applies for the shield members 506.1 and 506.2. For each of the shield members 506.1 and 506.2, a respective ground-contact field is provided. Due to the density of integrated-circuit components in the interior of the shielding hood 504, only a section of a ground-contact field 512 is clearly visible in the perspective views of Figures 8 and 9.

In the present embodiment, a RF power amplifier 508 forms the first integrated-circuit component and is positioned near the sidewall 504.2. The internal shield in the form of the shield members 506.1 and 506.2 provides effective shielding against undesired EMI effects by propagation of electromagnetic fields generated internally by the RF power amplifier and therefore protects RF-sensitive integrated-circuit components, in particular a baseband processor and RF modulator 510 placed centrally of the circuit board 502.

A smallest of the side lengths of the first and second integrated-circuit components 508 and 510 in the two principal lateral directions x and y is indicated in Fig. 8 as Sₘᵢₙ. In this case, it is the side length of the power amplifier 508 in y-direction. The largest lateral extension of the shield member 506.1 in the two principal directions is shown under Lₘₐₓ in Fig. 8. It is the lateral extension in y-direction. As can be seen, Lₘₐₓ is clearly smaller than Sₘᵢₙ, by a factor of approximately 4. The shield members 506.1 and 506.2 can thus be flexibly positioned with respect to their lateral position in the design process. An arrangement as flexibly adaptable in the design process as this would not have been possible with the concept of the prior art as shown in Figures 1 and 2, which uses the planar shielding wall 106. It is for instance visible that the shield members 506.1 and 506.2 both have their largest lateral extension in y-direction, parallel to that edge 502.1 of the circuit board, near which the sidewall 504.4 is mounted. However, they are not arranged along an identical straight line running parallel that edge 502.1 of the circuit board 502, but placed at slightly different distances from that edge 502.1, as indicated by dashed lines x1 and x2. The placement is thus shown to have been made in accordance with the requirements of the circuit board design, in particular the placement of integrated-circuit components.

It is clearly visible from Fig. 8 that the use of the shield members 506.1 and 506.2 also allows increasing surface area that is available in the design process for arranging integrated-circuit components on the surface of the circuit board 502. The resulting RF-circuit module comprises a very high density of integrated-circuit components on a rather small surface.

It is noted that the shield members 506.1 and 506.2 also have an advantageous effect on the stability of the shielding hood 504 against the application of pressure, in particular having pressure components pointing in a direction perpendicular to the top surface 504.1 of the shielding hood 504 and towards the surface of the circuit board 502. Additional shield members may be used that are not required for the purpose of shielding electromagnetic fields but further increase the mechanical stability of the shielding hood against such external pressure.

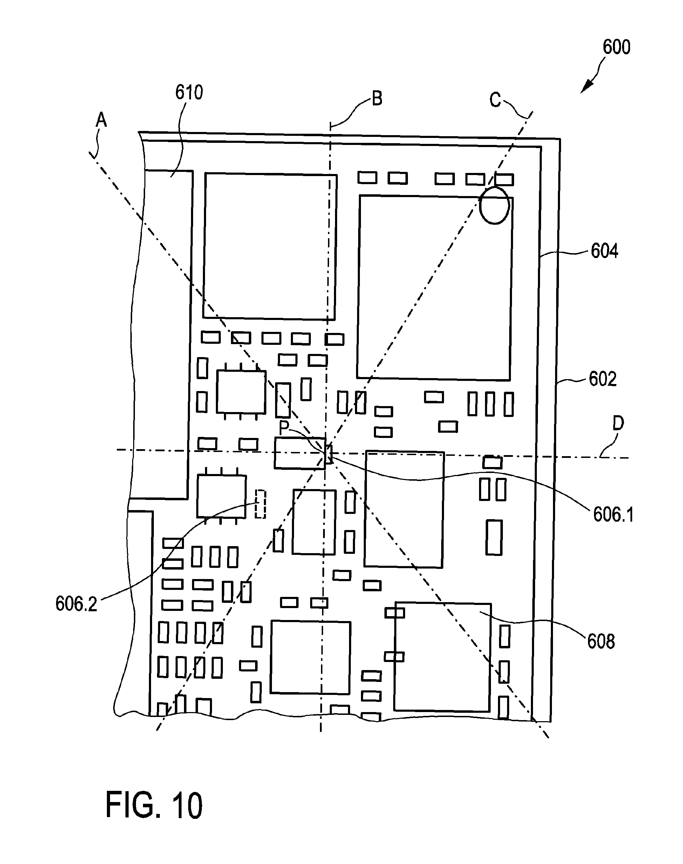

Fig. 10 shows top view of a section further embodiment of an RF circuit module 600 according to the present invention. In the graphical representation of Fig. 10, integrated-circuit components, such as the first and second integrated-circuit components 608 and 610 are shown by their rectangular outlines. The position of shield members 606.1 and 606.2 forming the internal shield is shown by dashed outlines. The outline of the top face of the shielding hood 604 is also indicated. The present embodiment is representative for the dense arrangement of integrated-circuit components that can be achieved using the present invention. This high density achieved can best be described in that any straight line that can be drawn on the surface of the circuit board 602 cutting through any lateral position P of the shield member 606.1 crosses at least one further integrated-circuit component mounted on the carrier surface. Exemplary straight lines A to D are shown in Fig. 10. They all cut through other integrated-circuit components.

The same applies for any straight line (not shown) cutting through the lateral position of the other shown shield member 606.2. In comparison, the prior-art arrangement shown in Fig. 1 allows straight lines passing through the lateral position of the shielding wall 106 to not cross any integrated-circuit component arranged on the circuit board 102. For instance, the straight line running parallel to the shielding wall 106 does not cross any integrated-circuit component.

The effect of the shield members 606.1 and 606.2 was experimentally determined by determining a root-mean-square (RMS) phase error generated in an output signal of the EMI sensitive baseband and RF modulator 610 in embodiments with and without the inventive internal shield design under application of external pressure to the shielding hood 604. The RMS phase error is a performance measure which describes the exactness of the RF Modulator in converting the base band signal into the RF domain. In conjunction with an Error Vector Magnitude (EVM), which is also sensitive to and affected by EMI, the exactness of the RF modulator can be completely characterized. In GSM/EDGE modules, e.g., a maximum RMS phase error of 5° is allowed. The phase error can thus be used as a criterion to rate the improvement achieved by an internal shield. Further affected parameters are the transmitter RF spectrum and the receiver sensitivity. Potentially sources of electromagnetic fields causing EMI are for instance a RF power amplifier, a memory, a switch power regulator. Examples of sensitive and potentially affected circuits are an RF modulator and an RF receiver.

While the RMS phase error observed without any internal shield was measured to be 5.5°, the measured phase error of this signal dropped to 2.7° upon providing only the shield member 606.1, and further decreased to 2.2° by additionally introducing the second shield member 606.2. This result shows that a major reduction of the internal EMI can be achieved with only a single shield member laterally arranged between the first and second integrated-circuit components. It forms an effective internal shield.

The present invention thus provides an advantageous new EMI protection design for any type of circuit module that requires internal shielding against electromagnetic fields generated by a integrated-circuit component on the circuit board of the circuit module in addition to shielding from external electromagnetic fields by means of a shielding hood.

## Claims

1. A radio frequency circuit module comprising
a carrier having a carrier surface, on which at least a first -integrated-circuit component forming a source of an electromagnetic field and a and second -integrated-circuit component, whose function is impaired by the electromagnetic field, are mounted at a distance from each other;
a metallic shielding hood for reducing electromagnetic interference between electromagnetic fields in an exterior of the shielding hood and electromagnetic fields in the interior of the shielding hood, the shielding hood encapsulating at least the first and the second integrated-circuit component; and
an internal shield laterally arranged between the first and second integrated-circuit components in the interior of the shielding hood and extending vertically from a top section of the shielding hood to a ground-potential contact, for reducing electromagnetic interference between the first and the second integrated-circuit components,
wherein the internal shield is formed by one or more shield members which, in any of two principal lateral directions which are parallel to the carrier surface, has a lateral extension that is smaller than the smallest of the side lengths of the first and second integrated-circuit components in the two principal lateral directions.

2. The radio frequency circuit module of claim 1, wherein the internal shield is formed by at most five shield members.

3. The radio frequency circuit module of at least one of the preceding claims, comprising at least two pin shaped members, which are in contact with a respective individual ground-potential contact field.

4. The radio frequency circuit module of at least one of the preceding claims, wherein at least one of the one or more ground-potential contact fields is arranged on the carrier surface.

5. The radio frequency circuit module of at least one of the preceding claims, wherein at least one of the one or more ground-potential contact fields is arranged on a cover of a third integrated-circuit component that is mounted on the carrier surface.

6. The radio frequency circuit module of at least one of the preceding claims, wherein the shield member is cut out or punched out of the top section of the shielding hood and bent towards the interior of the shielding hood.

7. The radio frequency circuit module of at least one of the preceding claims, wherein any straight line that can be drawn on the carrier surface cutting through a lateral position of the at least one shield member crosses at least one further integrated-circuit component mounted on the carrier surface.

8. The radio frequency circuit module of at least one of the preceding claims, wherein the shield member has the shape of a pin, a tab or a blade.
